# EUROPÄISCHE PATENTSCHRIFT

(11) **EP 0 574 465 B1**
(45) Veröffentlichungstag und Bekanntmachung des Hinweises auf die Patenterteilung: **12.06.1996**
(21) Anmeldenummer: 92905891.5
(22) Anmeldetag: 04.03.1992
(51) Int. Cl.: A61B 5/04, H03H 17/02

(54) **ANORDNUNG ZUM HERAUSFILTERN VON GRUNDLINIENSCHWANKUNGEN AUS PHYSIOLOGISCHEN MESSSIGNALEN**
DEVICE FOR FILTERING OUT BASELINE FLUCTUATIONS FROM PHYSIOLOGICAL MEASUREMENT SIGNALS
AGENCEMENT POUR L'EXTRACTION PAR FILTRAGE D'OSCILLATIONS DE LA LIGNE DE BASE DANS DES SIGNAUX DE MESURE PHYSIOLOGIQUES

(30) Priorität: 04.03.1991 DE 4106858
(43) Veröffentlichungstag der Anmeldung: 22.12.1993
(73) Patentinhaber: Siemens Elema AB, S-171 95 Solna 1 (SE); SIEMENS AKTIENGESELLSCHAFT, D-80333 München (DE)
(72) Erfinder: LUNDSTRÖM, Lena, S-117 28 Stockholm (SE); KARLSSON, Peter, S-113 37 Stockholm (SE); OHLSSON, Thomas, S-162 43 Vällingby (SE)
(86) Internationale Anmeldenummer: EP9200474
(87) Internationale Veröffentlichungsnummer: WO9215243

(56) Entgegenhaltungen:
- EP-A- 0 281 101
- DD-A- 210 148
- US-A- 4 896 152
- JOURNAL OF CLINICAL ENGINEERING Bd. 7, Nr. 3, Juli 1982, BREA (US) Seiten 235 - 240; J.P. MARQUES DE SA: 'DIGITAL FIR FILTERING FOR REMOVAL OF ECG BASELINE WANDER' on der Anmeldung erwähnt
- R. King et al., "Digital Filtering in One and Two Dimensions", Plenum Press, New York und London, 1989, Seiten 40 - 43, 48 - 49, 134 - 137, 154 - 157, 418

## Beschreibung

Die Erfindung betrifft eine Anordnung zum Herausfiltern von Grundlinienschwankungen aus physiologischen Meßsignalen mit einer Abtaststufe zur Bildung von Abtastwerten der Meßsignale, einem daran angeschlossenen ersten Tiefpaßfilter, einer nachgeordneten Stufe zur Reduzierung der Abtastrate um einen vorgegebenen Faktor, einem nachfolgenden nichtrekursiven zweiten Tiefpaßfilter, einer anschließenden Interpolationsstufe zur Erhöhung der Abtastrate um den vorgegebenen Faktor und mit einer Subtrahierstufe zur Subtraktion der von der Interpolationsstufe kommenden Abtastwerte von den von der Abtaststufe kommenden Abtastwerten des physiologischen Meßsignales.

Physiologische Meßsignale, die von Patienten abgenommen werden, sind normalerweise von Störsignalen, wie z.B. der von dem Wechselstromnetz induzierten 50 Hz- Wechselspannung, muskelelektrischen Potentialen und Artefakten im Zusammenhang mit der Abnahme der physiologischen Meßsignale von dem Patienten überlagert. Diese Störungen äußern sich, soweit sie im Vergleich zu der charakteristischen Frequenz der physiologischen Meßsignale niederfrequenter Art sind, in Form von Grundlinienschwankungen in dem erfaßten Meßsignalverlauf.

Aus "Journal of Clinical Engineering", Bd. 7, Nr. 3, Juli-Sept. 1982, Seiten 235-240, ist eine Anordnung der oben genannten Art zur Herausfilterung von Grundlinienschwankungen aus einem Elektrokardiogramm bekannt. Bei der bekannten Anordnung werden die Grundlinienschwankungen aus dem in Form von Abtastwerten vorliegenden Elektrokardiogramm in einem Hochpaßfilter herausgefiltert, das aus einem ersten nichtrekursiven Tiefpaßfilter mit einer nachgeordneten Stufe zur Reduzierung der Abtastrate um den Faktor 8, einem daran anschließenden zweiten nichtrekursiven Tiefpaßfilter, einer nachfolgenden Interpolationsstufe zur Erhöhung der Abtastrate um den Faktor 8 und einer Subtrahierstufe besteht, in der die durch die Tiefpaßfilterung erhaltenen Grundlinienschwankungen von dem mit den Grundlinienschwankungen behafteten Elektrokardiogramm subtrahiert werden. Durch die Verwendung von nichtrekursiven (FIR-) Filtern, die durch eine Impulsantwort mit einer begrenzten Impulszahl (finite impulse reponse) charakterisiert sind, werden Phasenverschiebungen und damit Signalverzerrungen bei der Filterung vermieden. Jedoch ist der Rechenaufwand, daß heißt die Anzahl der in dem Filter auszuführenden Rechenoperationen (Multiplikationen) bei nichtrekursiven Filtern sehr hoch, weswegen bei der bekannten Anordnung die Abtastrate des Elektrokardiogramms um den Faktor 8 reduziert wird, bevor das Elektrokardiogramm dem zweiten nichtrekursiven Tiefpaßfilter zugeführt wird. Das erste Tiefpaßfilter dient dabei zu der für die Reduzierung der Abtastrate erforderlichen Frequenzbegrenzung des Elektrokardiogramms. Je größer der Reduktionsfaktor ist, um so geringer ist zwar der Rechenaufwand bei dem zweiten nichtrekursiven Filter, jedoch nimmt gleichzeitig der Rechenaufwand bei dem ersten nichtrekrusiven Filter zu. Daher ist bei der bekannten Anordnung vor der eigentlichen Grundlinienfilterung eine Vorfilterung mit einer Abtastratenreduktion um den Faktor 2 vorgesehen, wodurch die Auflösung des Elektrokardiogramms insgesamt verringert wird.

Der Erfindung liegt die Aufgabe zugunde, beim Herausfiltern von Grundlinienschwankungen aus physiologischen Meßsignalen den erforderlichen Rechenaufwand bei der Abtastfilterung zu verringern.

Zur Lösung der Aufgabe ist erfindungsgemäß bei der Anordnung der eingangs angegebenen Art das erste Tiefpaßfilter ein rekursives Filter, dessen Grenzfrequenz in Bezug auf die Grenzfrequenz des zweiten Tiefpaßfilters so gewählt ist, daß von dem ersten Tiefpaßfilter hervorgerufene Phasenverschiebungen in dem zweiten Tiefpaßfilter herausgefiltert werden. Im Vergleich zu nichtrekursiven Filtern zeichnen sich nämlich rekursive Filter durch einen geringeren Rechenaufwand bezogen auf die Filterleistung bzw. Filterwirkung aus. Der Nachteil, daß rekursive Filter Phasenverschiebungen bei dem zu filternden Signal hervorrufen, tritt bei der erfindungsgemäßen Anordnung insoweit nicht auf, als der Frequenzbereich, in dem die Phasenverschiebungen praktisch wirksam sind, in dem zweiten Tiefpaßfilter herausgefiltert wird.

Eine Veringerung von Signalverzerrungen bei der Filterung wird in vorteilhafter Weise durch eine Verzögerungsstufe zur verzögerten Weiterleitung der von der Abtaststufe kommenden Abtastwerte an die Subtrahierstufe erzielt. Dabei wird für die Verzögerungsstufe die gleiche Verzögerung gewählt, wie sie in den Tiefpaßfiltern auftritt.

Wegen des verringerten Rechenaufwandes bei der Filterung findet die erfindungsgemäße Anordnung in vorteilhafter Weise bei der prozessgekoppelten, daß heißt on-line Analyse der physiologischen Signale Verwendung.

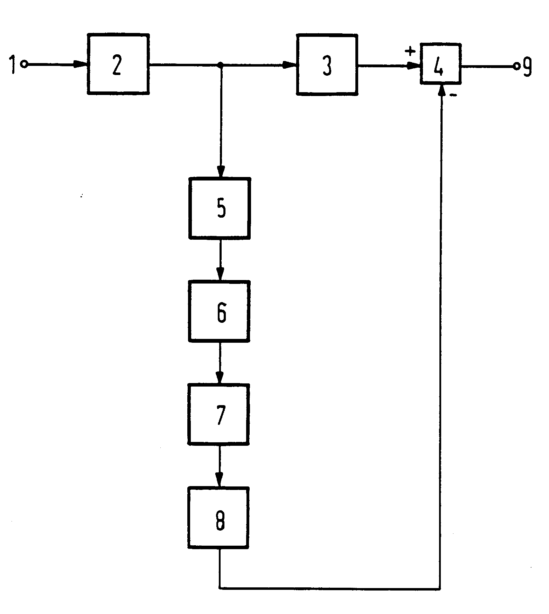

Zur Erläuterung der Erfindung wird im folgenden auf die Figur der Zeichnung Bezug genommen, die ein Ausführungsbeispiel der erfindungsgemäßen Anordnung in Form eines Blockschaltbildes zeigt.

Mit dem Bezugszeichen 1 ist ein Eingang der Anordnung bezeichnet, an dem ein physiologisches Meßsignal, beispielsweise ein von einem Patienten abgenommenes Elektrokardiogramm anliegt. An dem Eingang 1 ist eine Abtaststufe 2 zur Bildung von Abtastwerten des physiologischen Signals angeschlossen. Die Abtastwerte werden einerseits über eine Verzögerungsstufe 3 einem ersten Eingang (+) einer Subtrahierstufe 4 und andererseits über ein erstes Tiefpaßfilter, eine nachgeordnete Stufe 6 zur Reduzierung der Abtastrate, ein nachfolgendes zweites Tiefpaßfilter 7 und eine daran anschließende Interpolationsstufe 8 mit einem zweiten Eingang (-) der Subtrahierstufe 4 verbunden, an deren Ausgang das von den Grundlinienschwankungen befreite physiologische Meßsignal in Form von Abtastwerten zur weiteren prozessgekoppelten (on-line) Signalverarbeitung zur Verfügung steht. In den Blöcken 5 bis 8 wird das abgetastete physiologische Meßsignal tiefpaßgefiltert, so daß an dem zweiten Eingang (-) der Subtrahierstufe 4 die Abtastwerte der Grundlinienschwankungen erscheinen, welche in der Subtrahierstufe 4 von den Abtastwerten des physiologischen Meßsignals subtrahiert werden; die Blöcke 3 bis 8 bilden also ein Hochpaßfilter.

Das mit 7 bezeichnete Tiefpaßfilter ist ein nichtrekursives Filter, das bei der Filterung keine Phasenfehler erzeugt. Jedoch ist bei derartigen Filtern der Rechenaufwand, also die Zahl der durchzuführenden Rechenoperationen und die Signalverzögerung relativ hoch. Um beides zu verringern, wird die dem Tiefpaßfilter 7 zugeführte Rate von Abtastwerten reduziert. Das ist auf Grund der relativ niedrigen Frequenz der Grundlinienschwankungen möglich. Die Reduzierung der Abtastrate erfolgt in der Stufe 6. Das der Stufe 6 vorgeordnete Tiefpaßfilter 5 dient zu der für die Abtastratenreduzierung erforderlichen Frequenzbegrenzung des abgetasteten Meßsignals. Im Unterschied zu dem zweiten Filter 7 ist das erste Filter 5 eine rekursives Filter, bei dem der Rechenaufwand bezogen auf die Filterleistung erheblich geringer ist. Der Nachteil, daß das rekursive Filter 5 Phasenfehler in dem zu filternden Signal hervorruft, tritt nicht in Erscheinung, da die Grenzfrequenz des Filters 5 in Bezug auf die des Filters 7 so gewählt ist, daß die Phasenfehler in dem Filter 7 herausgefiltert werden.

Da die Tiefpaßfilterung in den Blöcken 5 bis 8 mit einer bestimmten Verzögerung erfolgt, wird das ungefilterte abgetastete Meßsignal parallel dazu in der Verzögerungsstufe 3 um denselben Betrag verzögert, um in der Subtrahierstufe 4 eine von Fehlern aufgrund von Verzögerungsunterschieden freie Subtraktion der Grundlinienschwankungen von den Meßsignal zu ermöglichen.

Bei dem gezeigten Ausführungsbeispiel zur Herausfilterung von Grundlinienschwankungen aus einem Elektrokardiogramm ist vorzugsweise eine Abtastrate in der Abtaststufe 2 von 500 Hz vorgesehen; der Reduktionsfaktor in der Stufe 5 beträgt 40. Die Anordnung arbeitet prozeßgekoppelt (on-line) mit einem Signalprozessor, von dessen Rechenkapazität nur Bruchteil für die Filterung in Anspruch genommen wird.

## Patentansprüche

1. Anordnung zum Herausfiltern von Grundlinienschwankungen aus physiologischen Meßsignalen mit einer Abtaststufe (2) zur Bildung von Abtastwerten der Meßsignale, einem daran angeschlossenen ersten Tiefpaßfilter (5), einer nachgeordneten Stufe (6) zur Reduzierung der Abtastrate um einen vorgegebenen Faktor, einem nachfolgenden nichtrekursiven zweiten Tiefpaßfilter (7), einer anschließenden Interpolationsstufe (8) zur Erhöhung der Abtastrate um den vorgegebenen Faktor und mit einer Subtrahierstufe (4) zur Subtraktion der von der Interpolationsstufe (8) kommenden Abtastwerte von den von der Abtaststufe (2) kommenden Abtastwerten des physiologischen Meßsignals, **dadurch gekennzeichnet**, daß das erste Tiefpaßfilter (5) ein rekursives Filter ist, dessen Grenzfrequenz in Bezug auf die Grenzfrequenz des zweiten Tiefpaßfilters (7) so gewählt ist, daß der Frequenzbereich, in dem die von dem ersten Tiefpaßfilter (5) hervorgerufenen Phasenverschiebungen liegen, in dem zweiten Tiefpaßfilter (7) herausgefiltert wird.

2. Anordnung nach Anspruch 1, **gekennzeichnet durch** eine Verzögerungsstufe (3) zur verzögerten Weiterleitung der von der Abtaststufe (2) kommenden Abtastwerte an die Subtrahierstufe (4).

3. Verwendung der Anordnung nach Anspruch 1 oder 2 zur prozeßgekoppelten Analyse oder on-line Analyse der physiologischen Meßsignale.

## Claims

1. Device for filtering out baseline fluctuations from physiological measurement signals, having a sampling stage (2) for the formation of sampled values of the measurement signals, a first low-pass filter (5) connected thereto, a downstream stage (6) for the reduction of the sampling rate by a predetermined factor, a subsequent non-recursive second low-pass filter (7), a subsequent interpolation stage (8) for increasing the sampling rate by the predetermined factor, and having a subtraction stage (4) for the subtraction of the sampled values coming from the interpolation stage (8) from the sampled values of the physiological measurement signal, coming from the sampling stage (2), characterized in that the first low-pass filter (5) is a recursive filter, the cutoff frequency of which is selected in relation to the cutoff frequency of the second low-pass filter (7) so that the frequency range within which the phase shifts caused by the first low-pass filter (5) lie is filtered out in the second low-pass filter (7).

2. Device according to Claim 1, characterized by a retardation stage (3) for the retarded onward transmission of the sampled values coming from the sampling stage (2) to the subtraction stage (4).

3. Use of the device according to Claim 1 or 2 for the process-coupled analysis or on-line analysis of the physiological measurement signals.

## Revendications

1. Dispositif pour filtrer des fluctuations de la ligne de base de signaux de mesure physiologiques, comportant un étage (2) d'échantillonnage pour former des valeurs d'échantillonnage des signaux de mesure, un premier filtre (5) passe-bas relié à cet étage, un étage (6) disposé à la suite pour réduire d'un facteur prédéterminé la fréquence d'échantillonnage, un second filtre (7) passe-bas non récursif disposé à la suite, un étage (8) d'interpolation relié au second filtre pour accroître, du facteur prédéterminé, la fréquence d'échantillonnage et un étage (4) soustracteur pour soustraire des valeurs d'échantillonnage, arrivant de l'étage (8) d'interpolation, des valeurs d'échantillonnage du signal de mesure physiologique, qui viennent de l'étage (2) d'échantillonnage, caractérisé par le fait que le premier filtre (5) passe-bas est un filtre récursif, dont la fréquence limite est choisie par rapport à la fréquence limite du second filtre (7) passe-bas de telle sorte que la gamme de fréquences, dans laquelle sont situés les déphasages provoqués par le premier filtre (5) passe-bas, est séparée par filtrage dans le second filtre (7) passe-bas.

2. Dispositif suivant la revendication 1, caractérisé par un étage (3) de retardement pour la transmission retardée des valeurs d'échantillonnage, qui arrivent de l'étage (2) d'échantillonnage, à l'étage (4) soustracteur.

3. Utilisation du dispositif selon la revendication 1 ou 2 pour l'analyse couplée au processus ou analyse on-line des signaux de mesure physiologiques.
